# EUROPEAN PATENT SPECIFICATION

(11) **EP 4 372 400 B1**
(45) Date of publication and mention of the grant of the patent: **25.03.2026**
(21) Application number: 22919036.8
(22) Date of filing: 08.12.2022
(51) Int. Cl.: G01R 31/396, G01R 31/371, G01R 31/36, G01R 23/16, G01R 19/00, H04L 25/02, H04L 12/40, H02J 7/00, G01R 31/3835

(54) **BATTERY MANAGEMENT SYSTEM PROVIDING NOISE CANCELLATION OF CAN COMMUNICATION, ENERGY STORAGE SYSTEM, AND BATTERY SYSTEM**
BATTERIEVERWALTUNGSSYSTEM MIT RAUSCHUNTERDRÜCKUNG VON CAN-KOMMUNIKATION, ENERGIESPEICHERSYSTEM UND BATTERIESYSTEM
SYSTÈME DE GESTION DE BATTERIE PROCURANT UNE ANNULATION DE BRUIT DE COMMUNICATION CAN, SYSTÈME DE STOCKAGE D'ÉNERGIE ET SYSTÈME DE BATTERIE

(30) Priority: 05.01.2022 KR 20220001803
(43) Date of publication of application: 22.05.2024
(73) Proprietor: LG ENERGY SOLUTION, LTD., Seoul 07335 (KR)
(72) Inventor: LEE, Muyeon, Daejeon 34122 (KR)
(74) Representative: Plasseraud IP
(86) International application number: PCT/KR2022/019978
(87) International publication number: WO 2023/132499

(56) References cited:
- KR-A- 20190 069 889
- KR-B1- 101 156 342
- KR-B1- 101 222 248
- US-A1- 2005 135 331
- US-A1- 2019 028 303
- US-A1- 2020 317 085
- US-A1- 2021 151 996

## Description

### [Technical Field]

The present invention relates to a battery management system, an energy storage device, and a battery system for removing noise in CAN communication.

### [Background Art]

Controller Area Network (CAN) communication is a communication method for exchanging data by connecting a plurality of controllers in parallel. In addition, CAN communication has an advantage in that all controllers sharing a communication line act as masters, so that all controllers can communicate whenever necessary. Due to this advantage, CAN communication is used in various fields, such as automobile systems, energy storage systems, and medical systems.

In CAN communication, a plurality of controllers communicates by being connected in parallel to a CAN bus, and is capable of communicating at a speed of several kHz to several MHZ depending on the application. A CAN communication system providing CAN communication is configured so that each controller includes a filter (e.g., capacitor) capable of effectively removing noise without affecting CAN communication in order to improve communication quality. At this time, a cut-off frequency is determined according to the total capacitance of all capacitors included in the CAN communication system.

On the other hand, when the number of controllers connected in parallel to the CAN bus increases, the total sum of capacitance the capacitors included in each controller (parallel sum of capacitors) increases, and CAN communication may not be smooth. For example, a GRID system can have 1 to 21 controllers connected to the CAN bus. As another example, in a household energy storage system (ESS), 1 to 4 controllers may be connected to the CAN bus.

However, the existing CAN communication system uses a capacitor having a fixed capacitance, even when the number of controllers connected in parallel to the CAN bus increases or the CAN communication frequency changes, the capacitance of the capacitor cannot be changed, so that there was a problem with the quality of CAN communication dropping. In addition, in the existing CAN communication system, when the number of controllers is changed, there is a problem in that the existing capacitor must be replaced with a new capacitor in order to effectively remove noise. The documents US 2019/028303 A1 and US 2005/135331 A1 are known, but fail to cure the above mentioned deficiencies.

### [Disclosure]

### [Technical Problem]

The present invention provides a battery management system (BMS), an energy storage device, and a battery system capable of easily varying the capacitance of a capacitor in a filter without replacing a filter for removing noise in CAN communication.

### [Technical Solution]

A battery management system according to one characteristic of the present invention is a battery management system for managing a battery pack including a plurality of battery cells connected in series, the battery management system including: a variable capacitor connected between a Controller Area Network (CAN) communication line and a ground, wherein a capacitance of the variable capacitor varies according to a voltage level supplied to the variable capacitor; a switching unit including a plurality of resistors connected between an external power source and the ground and a plurality of switches electrically connecting each of the plurality of resistors and the variable capacitor; and a control unit for controlling the switching unit so that a voltage of the external power source is transmitted to the variable capacitor.

The control unit may control the switching unit so that the capacitance of the variable capacitor corresponds to a preset noise cut-off frequency.

The variable capacitor may include: a first variable capacitor connected between a first CAN communication line and the ground, and a second variable capacitor connected between a second CAN communication line and the ground.

The switching unit may include: a first switching unit including a plurality of first resistors among the plurality of resistors that are connected in series between the external power source and the ground and a plurality of first switches among the plurality of switches that are electrically connecting one end of each of the plurality of first resistors and one end of the first variable capacitor; and a second switching unit including a plurality of second resistors among the plurality of resistors that are connected in series between the external power source and the ground and a plurality of second switches among the plurality of switches that are electrically connecting one end of each of the plurality of second resistors and one end of the second variable capacitor.

An energy storage system according to another characteristic of the present invention includes: a battery including a plurality of battery packs, each battery pack including a plurality of battery cells; a plurality of slave BMSs for managing each of the plurality of battery packs; and a master BMS for managing the plurality of slave BMSs through Controller Area Network (CAN) communication, in which each of the plurality of slave BMSs includes: a variable capacitor connected between a CAN communication line and the ground, wherein a capacitance of the variable capacitor varies according to a voltage level supplied to the variable capacitor; a switching unit including a plurality of resistors connected between a power line of the master BMS and a ground and a plurality of switches electrically connecting the plurality of resistors and the variable capacitor, and a control unit controlling the switching unit so that the voltage supplied by the master BMS is transmitted to the variable capacitor.

Each of the plurality of slave BMS may control a switching operation of at least one of the plurality of switches such that a capacitance of the variable capacitor corresponds to a preset noise cut-off frequency.

Each of the plurality of slave BMSs may receive a switching control signal from the master BMS through the CAN communication line and controls the switching unit according to the switching control signal.

The variable capacitor may include: a first variable capacitor connected between a first CAN communication line and the ground, and a second variable capacitor connected between a second CAN communication line and the ground.

The switching unit may include: a first switching unit including a plurality of first resistors among the plurality of resistors connected in series between a power line of the master BMS and a ground, and a plurality of first switches among the plurality of switches electrically connecting one end of each of the plurality of first resistors and one end of the first variable capacitor; and a second switching unit including a plurality of second resistors among the plurality of resistors connected in series between the power line of the master BMS and the ground, and a plurality of second switches among the plurality of switches electrically connecting one end of each of the plurality of second resistors and one end of the second variable capacitor.

A battery system according to still another characteristic of the present invention includes: a battery including a plurality of battery packs, each battery pack including a plurality of battery cells; a plurality of slave BMSs for managing each of the plurality of battery packs; and a master BMS for managing the plurality of slave BMSs through Controller Area Network (CAN) communication, in which each of the plurality of slave BMSs includes: a variable capacitor connected between a CAN communication line and a ground, wherein a capacitance of the variable capacitor varies according to a voltage level supplied to the variable capacitor; a switching unit including a plurality of resistors connected between a power line of the master BMS and the ground and a plurality of switches electrically connecting one end of each of the plurality of resistors and one end of the variable capacitor; and a control unit controlling the switching unit so that the voltage supplied by the master BMS is transmitted to the variable capacitor.

Each of the plurality of slave BMS may control a switching operation of at least one of the plurality of switches such that a capacitance of the variable capacitor corresponds to a preset noise cut-off frequency.

Each of the plurality of slave BMSs may receive a switching control signal from the master BMS through the CAN communication line and controls the switching unit according to the switching control signal.

### [Advantageous Effects]

Even when the number of plurality of controllers (e.g., slave BMS's) performing CAN communication and the CAN communication frequency are changed, the present invention may effectively remove noise without replacing filters (e.g., capacitors) connected in parallel to each of a plurality of controllers.

The cut-off frequency may be changed without replacing a filter, so that the present invention has an effect of saving time and cost.

### [Description of the Drawings]

FIG. 1 is a diagram illustrating a battery system according to an exemplary embodiment.
FIG. 2 is a diagram illustrating a filter inserted into a CAN communication line connecting a battery management system (BMS) of FIG. 1 and a CAN bus.
FIG. 3 is a first diagram describing a configuration of an arbitrary slave BMS PBMSj of FIG. 2 in detail.
FIG. 4 is a second diagram describing a configuration of an arbitrary slave BMS PBMSj of FIG. 2 in detail.

### [Mode for Invention]

Hereinafter, an exemplary embodiment disclosed the present specification will be described in detail with reference to the accompanying drawings, and the same or similar constituent element is denoted by the same reference numeral regardless of a reference numeral, and a repeated description thereof will be omitted. Suffixes, "module" and and/or "unit" for a constituent element used for the description below are given or mixed in consideration of only easiness of the writing of the specification, and the suffix itself does not have a discriminated meaning or role. Further, in describing the exemplary embodiment disclosed in the present disclosure, when it is determined that detailed description relating to well-known functions or configurations may make the subject matter of the exemplary embodiment disclosed in the present disclosure unnecessarily ambiguous, the detailed description will be omitted. Further, the accompanying drawings are provided for helping to easily understand exemplary embodiments disclosed in the present specification, and the technical spirit disclosed in the present specification is not limited by the accompanying drawings, and it will be appreciated that the present invention includes all of the modifications, equivalent matters, and substitutes included in the spirit and the technical scope of the present invention.

Terms including an ordinary number, such as first and second, are used for describing various constituent elements, but the constituent elements are not limited by the terms. The terms are used only to discriminate one constituent element from another constituent element.

It should be understood that when one constituent element is referred to as being "coupled to" or "connected to" another constituent element, one constituent element can be directly coupled to or connected to the other constituent element, but intervening elements may also be present. By contrast, when one constituent element is referred to as being "directly coupled to" or "directly connected to" another constituent element, it should be understood that there are no intervening elements.

In the present application, it will be appreciated that terms "including" and "having" are intended to designate the existence of characteristics, numbers, operations, operations, constituent elements, and components described in the specification or a combination thereof, and do not exclude a possibility of the existence or addition of one or more other characteristics, numbers, operations, operations, constituent elements, and components, or a combination thereof in advance.

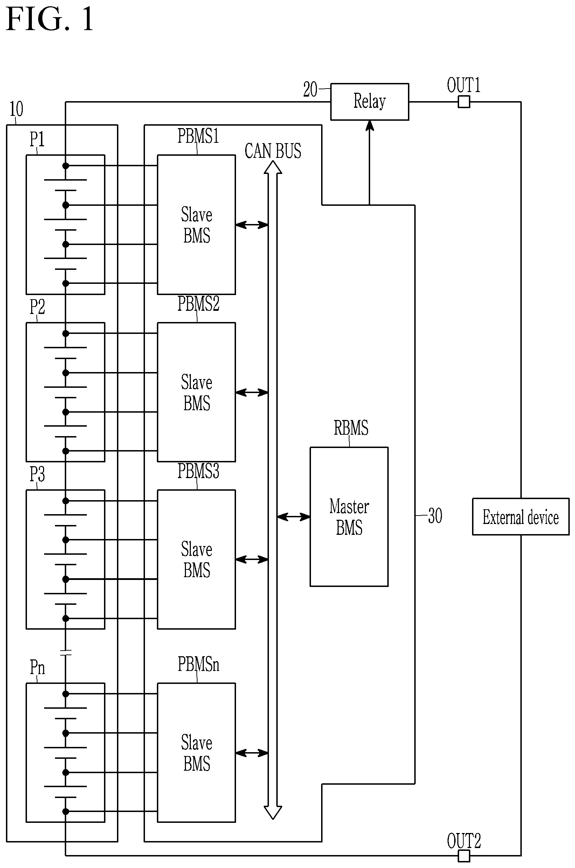

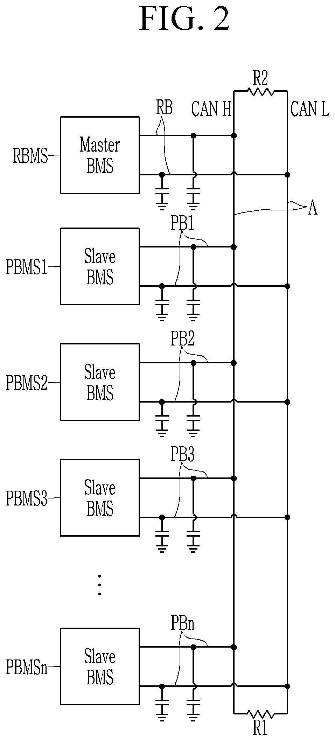

FIG. 1 is a diagram illustrating a battery system according to an exemplary embodiment, and FIG. 2 is a diagram illustrating a filter inserted into a CAN communication line connecting a battery management system (BMS) of FIG. 1 and a CAN bus.

Referring to FIG. 1, a battery system according to the exemplary embodiment includes a battery 10, a relay 20, and a battery management system (BMS) 30. An energy storage system (ESS) according to another exemplary embodiment includes a battery 10, a relay 20, and a battery management system (BMS) 30. Hereinafter, a battery system will be described, but all descriptions thereof may be equally applied to an energy storage system.

The battery 10 includes a plurality of battery packs P1 to Pn. Each of the plurality of battery packs P1 to Pn may include a plurality of battery cells connected in series. In some exemplary embodiments, the battery cell may be a rechargeable secondary battery. Each of the plurality of battery cells is electrically connected to a slave BMS PBMS, which is to be described below, through wires.

In FIG. 1, the battery 10 is connected between the two output terminals OUT1 and OUT2 of the battery system, and the relay 20 is connected between a positive electrode and the first output terminal OUT1 of the battery system. The configurations illustrated in FIG. 1 and the connection relationship between the configurations are examples, but the invention is not limited thereto.

The relay 20 controls electrical connection between the battery system and an external device. When the relay 20 is turned on, the battery system and the external device are electrically connected, so that charging or discharging is performed. when the relay 20 is turned off, the battery system 1 and the external device are electrically separated. In this case, the external device may be a charger in a charging cycle in which power is supplied to the battery 10 for charging, and may be a load in a discharging cycle in which the battery 10 discharges power to the external device.

The BMS 30 includes a plurality of slave BMSs PBMS1 to PBMSn and a master BMS RBMS.

The slave BMS PBMS is electrically connected to positive and negative electrodes of each of the plurality of battery cells included in a battery pack P to be managed, and measures a cell voltage of each of the plurality of battery cells. In addition, the slave BMS PBMS may receive a pack current value from a current sensor that measures a pack current flowing in the corresponding battery pack P, and receive a cell temperature value from a temperature sensor that measures a cell temperature of each of the plurality of battery cells included in the battery pack P. The slave BMS PBMS may transmit battery data including at least one of a cell voltage, a pack current, and a cell temperature to the master BMS RBMS.

The master BMS RBMS may manage a plurality of slave BMSs PBMS1 to PBMSn, and communicate with a higher level controller to control the plurality of slave BMSs PBMS1 to PBMSn according to a command from the higher level controller.

Communication between the plurality of slave BMSs PBMS1 to PBMSn and the master BMS RBMS uses CAN communication. Referring to FIG. 1, each of a plurality of slave BMSs PBMS1 to PBMSn and master BMS RBMS may perform CAN communication by using a CAN communication line connected to a Controller Area Network (CAN) bus.

For example, each of the plurality of slave BMSs PBMS1 to PBMSn may transfer battery data for the managed battery packs P1 to Pn to the master BMS RBMS through CAN communication. The master BMS RBMS may transmit a predetermined control signal to the plurality of slave BMSs PBMS1 to PBMSn through CAN communication.

Referring to FIGS. 1 and 2, each of a plurality of slave BMSs PBMS1 to PBMSn may be connected in parallel to the CAN bus through CAN communication lines PB1 to PBn. Specifically, when a first CAN communication line and a second CAN communication line are connected to parallel contact point of the twisted pair wire A of the CAN bus, a plurality of slave BMSs PBMS1 to PBMSn may be connected in parallel to the CAN bus. In addition, when the first CAN communication line and the second CAN communication line of the master BMS RBMS are connected to the parallel contact points of the twisted pair wire A of the CAN bus, the master BMS RBMS may be connected in parallel to the CAN bus. In this case, the first CAN communication line may correspond to a wire connected to CAN high CAN_H to be described below, and the second CAN communication line may correspond to a wire connected to CAN low CAN_L to be described below.

CAN communication is a method in which the plurality of slave BMSs PBMS1 to PBMSn and the master BMS RBMS (hereinafter, the plurality of BMSs) are connected in parallel to the CAN bus to communicate. The plurality of BMSs may transmit and receive data and control signals with a differential signal between a first signal and a second signal. For example, each of the plurality of BMSs may transmit and receive a first signal (for example, a high signal) to/from a wire connected to CAN high CAN_H, and transmit and receive a second signal (for example, a low signal) to/from a wire connected to CAN low CAN_L. For convenience of description below, the wire connected to the CAN high CAN_H will be described as a first CAN communication line CAN_H, and the wire connected to the CAN low CAN_L will be described as a second CAN communication line CAN_L.

In FIG. 2, first and second terminating resistors R1 and R2 may be connected to both ends of the CAN bus. The terminating resistors R1 and R2 may secure signal safety by absorbing energy of a reception mode carrier during high-speed signal transmission, and may provide an appropriate load for maintaining a voltage level. For the terminating resistors R1 and R2, for example, a resistor of 120Ω may be used, but the scope of the present invention is not limited thereto.

Hereinafter, a variable capacitor connected between the CAN communication line and the ground in order to remove noise in CAN communication will be described in detail.

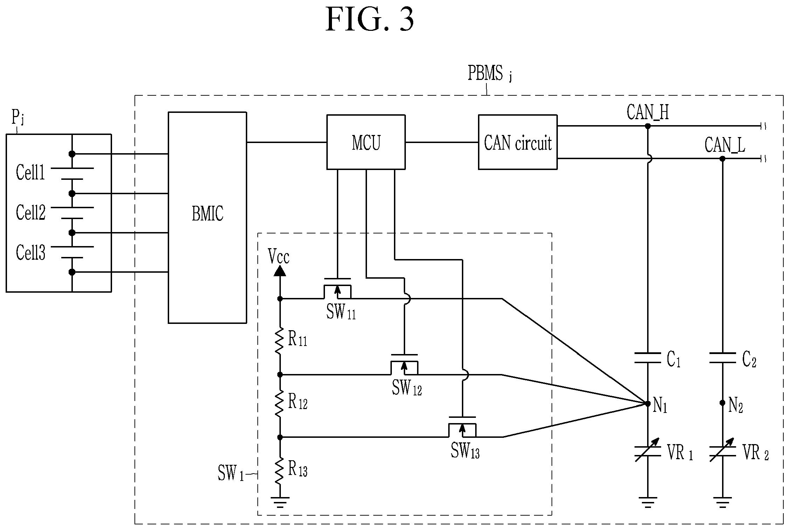

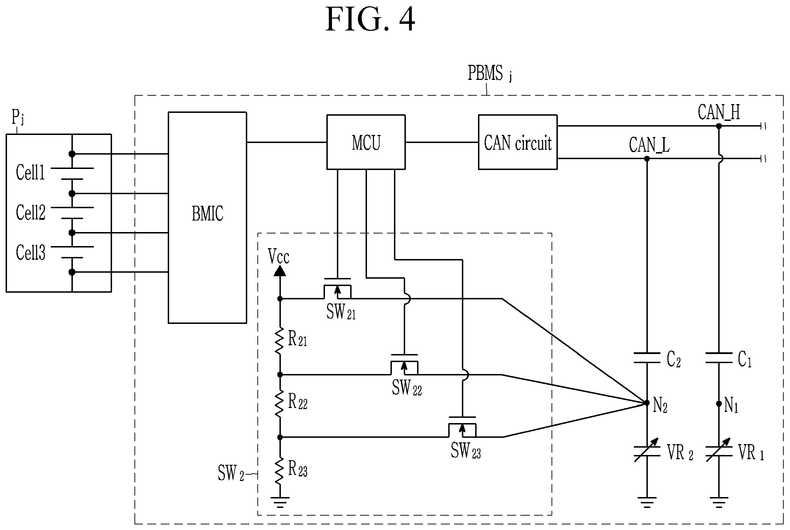

FIG. 3 is a first diagram describing a configuration of an arbitrary slave BMS PBMSj of FIG. 2 in detail, and FIG. 4 is a second diagram describing a configuration of the arbitrary slave BMS PBMSj of FIG. 2 in detail.

Specifically, FIG. 3 is a diagram describing in detail the configuration of a first switching unit SW1 and a first filter C1, VR1 of an arbitrary slave BMS PBMSj, and FIG. 4 is a diagram describing in detail the configuration of a second switching unit SW2 and a second filter C2, VR2 of the arbitrary slave BMS PBMSj.

Hereinafter, referring to FIGS. 1 to 4, the battery management system, an energy storage device, and a battery system for removing noise in CAN communication will be described in detail.

Referring to FIGS. 3 and 4, the slave BMS PBMS may include a control unit MCU, a communication unit (CAN circuit), filters C1, C2, VR1, VR2, a switching unit SW, and a monitoring IC BMIC.

Hereinafter, reference numeral "j" is used to designate a specific slave BMS among a plurality of slave BMSs PBMS1 to PBMSn, and a control unit, communication unit, a variable capacitor, a switching unit, and a monitoring IC included in the corresponding slave BMS PBMSj, respectively, use reference numerals "MCUj, CAN circuitj", "VRj", "SWj", and "BMICj". However, for convenience of description, in FIGS. 3 and 4, "j" is omitted from reference numerals of the control unit, the communication unit, the capacitor, the variable capacitor, the switching unit, and the monitoring IC.

The control unit MCU manages and controls the slave BMS PBMSj as a whole. According to the exemplary embodiment, referring to FIGS. 3 and 4, the control unit MCU controls a switching operation of the plurality of switches SW11 to SW23 included in the first switching unit SW1 and the second switching unit SW2.

The communication unit (e.g., CAN circuit) may include a CAN transceiver and a CAN controller to perform CAN communication. The communication unit (e.g., CAN circuit) may communicate by using a conventionally known CAN communication method, which is a well-known method, so other descriptions are omitted.

The filters may remove high-frequency noise higher than the CAN communication frequency (for example, 200 KHZ to 1 MHZ). According to the exemplary embodiment, the filters may include first filters C1 and VR1 and second filters C2 and VR2.

Referring to FIG. 3, the first filters may include a first capacitor C1 and a first variable capacitor VR1 connected in series between the first CAN communication line CAN_H and the ground. Also, referring to FIG. 4, the second filters may include a second capacitor C2 and a second variable capacitor VR2 connected in series between the second CAN communication line CAN_L and the ground.

The capacitors C1 and C2 may serve to block power supplied to the variable capacitors VR1-VR2 from being transferred to the CAN communication lines CAN_H and CAN_L. For example, as illustrated in FIG. 3, the first capacitor C1 may be connected between the first CAN communication line CAN_H and the first variable capacitor VR1.

When the power of an external power source VCC is supplied to a first point N1 by the first switching unit SW1 to be described below, the first capacitor C1 may block the transmission of the supplied power to the first CAN communication line CAN_H.

When the power of an external power source VCC is supplied to a second point N2 by the second switching unit SW2 to be described below, the second capacitor C2 may block the transmission of the supplied power to the second CAN communication line CAN_L. Hereinafter, the first CAN communication line may indicate a wire connected to the CAN high CAN_H communication line of the CAN bus, and the second CAN communication line may indicate a wire connected to the CAN low CAN_L communication line of the CAN bus.

The variable capacitors VR1 and VR2 may be filters that remove noise. For example, it is assumed that a CAN communication frequency is 500 kHz to 1 MHZ, and a high frequency of 1 MHZ or more is noise. According to the exemplary embodiment, 1MHZ is a cut-off frequency of noise, and the capacitance of the variable capacitors VR1 and VR2 is determined to remove frequencies higher than the cut-off frequency.

Referring to FIGS. 3 and 4, the variable capacitors VR1 and VR2 may be capacitors whose capacitance is variable in response to a level of the supplied voltage (hereinafter referred to as "supply voltage"). For example, the variable capacitors VR1 and VR2 may include varactors whose capacitance changes according to the voltage level of the supply voltage.

The varactor may include a variable capacitance range corresponding to, for example, 1pF to 100pF, and the capacitance may be controlled with a supply voltage of 0V to 20V. Table 1 below represents an example of a capacitance relationship corresponding to a voltage level in a predetermined varactor. However, this is an example, and in the case of the variable capacitors VR1 and VR2, the capacitance with respect to the level of the supplied voltage is not limited to Table 1 below.

**(Table 1)**

| Voltage (V) | Capacitance (pF) |
|---|---|
| 2V | 100pF |
| 2V | 70pF |
| 8V | 40pF |
| 12V | 30pF |
| 20V | 20pF |

According to the exemplary embodiment, the variable capacitors may include a first variable capacitor VR1 which is connected between the first CAN communication line CAN_H and the ground and whose capacitance changes in response to a level of a supplied voltage. The variable capacitors may further include a second variable capacitor VR2 which is connected between the second CAN communication line CAN_L and the ground and whose capacitance changes in response to a level of a supplied voltage.

The switching unit may connect the external power source VCC and one end of the variable capacitor VR1 or VR2 under the control of the control unit MCU. According to the exemplary embodiment, the switching units include a first switching unit SW1 connecting the external power source VCC and one end of the first variable capacitor VR1 under the control of the control unit MCU. Further, the switching units include a second switching unit SW2 connecting the external power source VCC and one end of the second variable capacitor VR2 under the control of the control unit MCU.

In FIG. 3, only the first switching unit SW1 is illustrated, but this is to simplify and clarify the representation of the drawing. Identically, in FIG. 4, only the second switching unit SW2 is illustrated, but this is to simplify and clarify the representation of the drawing. In summary, both the first switching unit SW1 and the second switching unit SW2 illustrated in FIGS. 3 and 4 may be included in one slave BMS PBMSj.

Referring to Figure 3, the first switching unit SW1 may include a plurality of first resistors R11 to R13 connected in series between the external power source VCC and the ground, and a plurality of first switches SW11 to SW13 connected between one end of each of the plurality of first resistors R11 to R13 and the first point N1 that is one end of the first variable capacitor VR1. In this case, the first point N1 may be a point between the first capacitor C1 and the first variable capacitor VR1. In addition, in FIG. 3, the number of first resistors and first switches is illustrated as three, but is not limited thereto, and the first resistors and the first switches may be configured in various numbers.

In FIG. 3, for example, the voltage level supplied to the first variable capacitor VR1 may vary according to the position of the first switch of the first switching unit SW1 that is turned on. When a first first switch SW11 is turned on (but, SW12 and SW13 are turned off), the voltage level of power supplied by the external power source VCC may be supplied to the first variable capacitor VR1. For another example, when a second first switch SW12 is turned on (but, SW11 and SW13 are turned off), a voltage level corresponding to the resistance ratio (R12+R13/R11 +R12+R13) of a second first resistor R12 and a third first resistor R13 to the total resistor R11 to R13 for the voltage level of the power supplied by the external power source VCC may be supplied to the first variable capacitor VR1. For another example, when a third first switch SW13 is turned on (but, SW11 and SW12 are turned off), a voltage level corresponding to the resistance ratio (R13/R11+R12+R13) of a third first resistance R13 to the total resistor R11 to R13 for the voltage level of the power supplied by the external power source VCC may be supplied to the first variable capacitor VR1.

Referring to FIG. 4, the second switching unit SW2 may include a plurality of second resistors R21 to R23 connected in series between the external power source VCC and the ground, and a plurality of second switches SW21 to SW23 connected between one end of each of the plurality of second resistors R21 to R23 and the second point N2 that is one end of the second variable capacitor VR2. In this case, the second point N2 may be a point between the second capacitor C2 and the second variable capacitor VR2. In addition, in FIG. 4, the number of second resistors and second switches is illustrated as three, but is not limited thereto, and the second resistors and the second switches may be configured in various numbers.

In FIG. 4, for example, the voltage level supplied to the second variable capacitor VR2 may vary according to the position of the second switch of the second switching unit SW2 that is turned on. When a first second switch SW21 is turned on (but, SW22 and SW23 are turned off), the voltage level of power supplied by the external power source VCC may be supplied to the second variable capacitor VR2. For another example, when a second second switch SW22 is turned on (but, SW21 and SW23 are turned off), a voltage level corresponding to the resistance ratio (R22+R23/R21+R22+R23) of a second second resistor R22 and a third second resistor R23 to the total resistor R21 to R23 for the voltage level of the power supplied by the external power source VCC may be supplied to the second variable capacitor VR2. For another example, when a third second switch SW23 is turned on (but, SW21 and SW22 are turned off), a voltage level corresponding to the resistance ratio of the third second resistor R23 to the total resistor R21 to R23 for the voltage level of the power supplied by the external power source VCC may be supplied to the second variable capacitor VR2.

The external power source VCC may be a master BMS RBMS. The master BMS RBMS may supply driving voltage (for example, 24V) required for driving the control unit MCU of each of the plurality of slave BMSs PBMS1 to PBMSn to the plurality of slave BMSs PBMS1 to PBMSn. That is, in the present invention, the slave BMS PBMSj may use the power supplied by the master BMS RBMS for the purpose of controlling the capacitance of the variable capacitors VR1 and VR2. However, the present invention is not limited thereto, and the external power source VCC may include various types of power sources capable of supplying power to the slave BMS PBMSj.

According to the exemplary embodiment, the plurality of switches SW11 to SW23 included in the switching units SW1 and SW2 may be formed of electronic switches. For example, the plurality of switches SW11 to SW23 may be formed of P-type or N-type field effect transistors (e.g., metal-oxide-semiconductor field-effect transistors MOSFETs). When the control unit MCU supplies a predetermined driving voltage to the gate of each of the plurality of switches SW11 to SW23, each of the plurality of switches SW11 to SW23 performs a turn-on switching operation.

The monitoring IC BMIC is electrically connected to one end and the other end of the plurality of battery cells included in the managed battery pack Pj to manage the battery pack Pj according to the control of the control unit MCU. In FIGS. 3 and 4, the plurality of battery cells Cell1 to Cell3 connected in series is illustrated as three, but is not limited thereto, and the battery pack Pj may include a plurality of battery cells in various numbers of 3 or more.

Referring to FIGS. 1 to 4, the master BMS RBMS may transmit a switching control signal to the CAN bus so that the capacitance of the variable capacitor VRj is changed to a capacitance corresponding to a preset noise cut-off frequency. For example, the master BMS RBMS may calculate a capacitance value corresponding to a preset noise cut-off frequency. For another example, the master BMS RBMS may receive a capacitance value corresponding to a preset noise cut-off frequency from a higher-level controller (e.g., ECU, and the like).

While this invention has been described in connection with what is presently considered to be practical exemplary embodiments, it is to be understood that the invention is not limited to the disclosed exemplary embodiments.

## Claims

1. A battery management system (30) for managing a battery pack (P1, P2, P3, Pi, Pn) including a plurality of battery cells connected in series, the battery management system (30) comprising:
a variable capacitor (VR1, VR2) connected between a Controller Area Network "CAN" communication line and a ground, wherein a capacitance of the variable capacitor (VR1, VR2) varies according to a voltage level supplied to the variable capacitor;
a switching unit (SW1, SW2) including:
a plurality of resistors (R11, R12, R13, R21, R22, R23) connected between an external power source (VCC) and the ground, and
a plurality of switches (SW11, SW12, SW13, SW21, SW22, SW23) electrically connecting each of the plurality of resistors (R11, R12, R13, R21, R22, R23) and the variable capacitor (VR1, VR2); and
a control unit (MCU) configured to control the switching unit so that a voltage of the external power source (VCC) is transmitted to the variable capacitor (VR1, VR2).

2. The battery management system (30) of claim 1, wherein:
the control unit (MCU) controls the switching unit (SW1, SW2) so that the capacitance of the variable capacitor (VR1, VR2) corresponds to a preset noise cut-off frequency.

3. The battery management system (30) of claim 1, wherein:
the variable capacitor (VR1, VR2) includes:
a first variable capacitor (VR1) connected between a first CAN communication line and the ground, and
a second variable capacitor (VR2) connected between a second CAN communication line and the ground.

4. The battery management system (30) of claim 3, wherein:
the switching unit includes:
a first switching unit (SW1) including a plurality of first resistors (R11, R12, R13) among the plurality of resistors (R11, R12, R13, R21, R22, R23) that are connected in series between the external power source and the ground and a plurality of first switches (SW11, SW12, SW13) among the plurality of switches (SW11, SW12, SW13, SW21, SW22, SW23) that are electrically connecting one end of each of the plurality of first resistors(R11, R12, R13) and one end of the first variable capacitor (VR1); and
a second switching unit (SW2) including a plurality of second resistors (R21, R22, R23) among the plurality of resistors (R11, R12, R13, R21, R22, R23) that are connected in series between the external power source (VCC) and the ground and a plurality of second switches (SW21, SW22, SW23) among the plurality of switches (SW11, SW12, SW13, SW21, SW22, SW23) that are electrically connecting one end of each of the plurality of second resistors (R21, R22, R23) and one end of the second variable capacitor (VR2).

5. An energy storage system, comprising:
a battery (10) including a plurality of battery packs (P1, P2, P3, Pi, Pn), each battery pack including a plurality of battery cells;
a plurality of slave battery management systems "BMSs" (30) according to any one of claims 1 to 4 configured to manage each of the plurality of battery packs (P1, P2, P3, Pi, Pn) ; and
a master BMS configured to manage the plurality of slave BMSs through Controller Area Network "CAN" communication.

6. The energy storage system of claim 5, wherein:
each of the plurality of slave BMSs receives a switching control signal from the master BMS through the CAN communication line and controls the switching unit (SW1, SW2) according to the switching control signal.

7. A battery system, comprising:
a battery including a plurality of battery packs P1, P2, P3, Pi, Pn) i, each battery pack including a plurality of battery cells;
a plurality of slave battery management systems "BMSs" (30) according to any one of claims 1 to 4 configured to manage each of the plurality of battery packs; and
a master BMS configured to manage the plurality of slave BMSs through Controller Area Network "CAN" communication..

8. The battery system of claim 7, wherein:
each of the plurality of slave BMSs receives a switching control signal from the master BMS through the CAN communication line and controls the switching unit (SW1, SW2) according to the switching control signal.

## Patentansprüche

1. Batterieverwaltungssystem (30) zum Verwalten eines Batteriepacks (P1, P2, P3, Pi, Pn), welcher eine Mehrzahl von Batteriezellen umfasst, welche in Reihe geschaltet sind, wobei das Batterieverwaltungssystem (30) umfasst:
einen variablen Kondensator (VR1, VR2), welcher zwischen eine Controller-Area-Network-"CAN"-Kommunikationsleitung und eine Erdung geschaltet ist, wobei eine Kapazität des variablen Kondensators (VR1, VR2) gemäß einem Spannungsniveau variiert, welches dem variablen Kondensator zugeführt wird;
eine Schalteinheit (SW1, SW2), umfassend:
eine Mehrzahl von Widerständen (R11, R12, R13, R21, R22, R23), welche zwischen eine externe Energiequelle (VCC) und die Erdung geschaltet sind, und
eine Mehrzahl von Schaltern (SW11, SW12, SW13, SW21, SW22, SW23), welche jeden aus der Mehrzahl von Widerständen (R11, R12, R13, R21, R22, R23) und den variablen Kondensator (VR1, VR2) elektrisch verbinden; und
eine Steuereinheit (MCU), welche dazu eingerichtet ist, die Schalteinheit derart zu steuern, dass eine Spannung der externen Energiequelle (VCC) an den variablen Kondensator (VR1, VR2) übertragen wird.

2. Batterieverwaltungssystem (30) nach Anspruch 1, wobei:
die Steuereinheit (MCU) die Schalteinheit (SW1, SW2) derart steuert, dass die Kapazität des variablen Kondensators (VR1, VR2) einer vorfestgelegten Rauschen-Abschaltefrequenz entspricht.

3. Batterieverwaltungssystem (30) nach Anspruch 1, wobei:
der variable Kondensator (VR1, VR2) umfasst:
einen ersten variablen Kondensator (VR1), welcher zwischen eine erste CAN-Kommunikationsleitung und die Erdung geschaltet ist, und
einen zweiten variablen Kondensator (VR2), welcher zwischen eine zweite CAN-Kommunikationsleitung und die Erdung geschaltet ist.

4. Batterieverwaltungssystem (30) nach Anspruch 3, wobei:
die Schalteinheit umfasst:
eine erste Schalteinheit (SW1), welche eine Mehrzahl erster Widerstände (R11, R12, R13) unter der Mehrzahl von Widerständen (R11, R12, R13, R21, R22, R23), welche zwischen die externe Energiequelle und die Erdung geschaltet sind, und eine Mehrzahl erster Schalter (SW11, SW12, SW13) unter der Mehrzahl von Schaltern (SW11, SW12, SW13, SW21, SW22, SW23) umfasst, welche ein Ende jedes aus der Mehrzahl erster Widerstände (R11, R12, R13) und ein Ende des ersten variablen Kondensators (VR1) elektrisch verbinden; und
eine zweite Schalteinheit (SW2), welche eine Mehrzahl zweiter Widerstände (R21, R22, R23) unter der Mehrzahl von Widerständen (R11, R12, R13, R21, R22, R23), welche zwischen die externe Energiequelle und die Erdung geschaltet sind, und eine Mehrzahl zweiter Schalter (SW21, SW22, SW23) unter der Mehrzahl von Schaltern (SW11, SW12, SW13, SW21, SW22, SW23) umfasst, welche ein Ende jedes aus der Mehrzahl zweiter Widerstände (R21, R22, R23) und ein Ende des zweiten variablen Kondensators (VR2) elektrisch verbinden.

5. Energiespeichersystem, umfassend:
eine Batterie (10), welche eine Mehrzahl von Batteriepacks (P1, P2, P3, Pi, Pn) umfasst, wobei jeder Batteriepack eine Mehrzahl von Batteriezellen umfasst;
eine Mehrzahl von Slave-Batterieverwaltungssystemen "BMS" (30) nach einem der Ansprüche 1 bis 4, welche dazu eingerichtet sind, jeden aus der Mehrzahl von Batteriepacks (P1, P2, P3, Pi, Pn) zu verwalten; und
ein Master-BMS, welches dazu eingerichtet ist, die Mehrzahl von Slave-BMS mittels Controller-Area-Network-"CAN"-Kommunikation zu verwalten.

6. Energiespeichersystem nach Anspruch 5, wobei:
jedes aus der Mehrzahl von Slave-BMS von der Master-BMS mittels der CAN-Kommunikationsleitung ein Schalt-Steuersignal empfängt und die Schalteinheit (SW1, SW2) gemäß dem Schalt-Steuersignal steuert.

7. Batteriesystem, umfassend:
eine Batterie, welche eine Mehrzahl von Batteriepacks (P1, P2, P3, Pn) i umfasst, wobei jeder Batteriepack eine Mehrzahl von Batteriezellen umfasst;
eine Mehrzahl von Slave-Batterieverwaltungssystemen "BMS" (30) nach einem der Ansprüche 1 bis 4, welche dazu eingerichtet sind, jeden aus der Mehrzahl von Batteriepacks zu verwalten; und
ein Master-BMS, welches dazu eingerichtet ist, die Mehrzahl von Slave-BMS mittels Controller-Area-Network-"CAN"-Kommunikation zu verwalten.

8. Batteriesystem nach Anspruch 7, wobei:
jedes aus der Mehrzahl von Slave-BMS von der Master-BMS mittels der CAN-Kommunikationsleitung ein Schalt-Steuersignal empfängt und die Schalteinheit (SW1, SW2) gemäß dem Schalt-Steuersignal steuert.

## Revendications

1. Système de gestion de batterie (30) pour la gestion d'un bloc-batterie (P1, P2, P3, Pi, Pn) comportant une pluralité d'éléments de batterie connectés en série, le système de gestion de batterie (30) comprenant :
un condensateur variable (VR1, VR2) connecté entre une ligne de communication de réseau de zone de contrôleur « CAN » et une masse, dans lequel une capacité du condensateur variable (VR1, VR2) varie selon un niveau de tension alimentant le condensateur variable ;
une unité de commutation (SW1, SW2) comportant :
une pluralité de résistances (R11, R12, R13, R21, R22, R23) connectées entre une source électrique externe (VCC) et la masse, et
une pluralité de commutateurs (SW11, SW12, SW13, SW21, SW22, SW23) connectant électriquement chacune de la pluralité de résistances (R11, R12, R13, R21, R22, R23) et le condensateur variable (VR1, VR2) ; et
une unité de commande (MCU) configurée pour commander l'unité de commutation de sorte qu'une tension de la source électrique externe (VCC) soit transmise au condensateur variable (VR1, VR2).

2. Système de gestion de batterie (30) selon la revendication 1, dans lequel :
l'unité de commande (MCU) commande l'unité de commutation (SW1, SW2) de sorte que la capacité du condensateur variable (VR1, VR2) corresponde à une fréquence de coupure de bruit prédéfinie.

3. Système de gestion de batterie (30) selon la revendication 1, dans lequel :
le condensateur variable (VR1, VR2) comporte :
un premier condensateur variable (VR1) connecté entre une première ligne de communication de CAN et la masse, et
un second condensateur variable (VR2) connecté entre une seconde ligne de communication de CAN et la masse.

4. Système de gestion de batterie (30) selon la revendication 3, dans lequel :
l'unité de commutation comporte :
une première unité de commutation (SW1) comportant une pluralité de premières résistances (R11, R12, R13) parmi la pluralité de résistances (R11, R12, R13, R21, R22, R23) qui sont connectées en série entre la source électrique externe et la masse et une pluralité de premiers commutateurs (SW11, SW12, SW13) parmi la pluralité de commutateurs (SW11, SW12, SW13, SW21, SW22, SW23) qui connectent électriquement une borne de chacune de la pluralité de premières résistances (R11, R12, R13) et une borne du premier condensateur variable (VR1) ; et
une seconde unité de commutation (SW2) comportant une pluralité de secondes résistances (R21, R22, R23) parmi la pluralité de résistances (R11, R12, R13, R21, R22, R23) qui sont connectées en série entre la source électrique externe (VCC) et la masse et une pluralité de seconds commutateurs (SW21, SW22, SW23) parmi la pluralité de commutateurs (SW11, SW12, SW13, SW21, SW22, SW23) qui connectent électriquement une borne de chacune de la pluralité de secondes résistances (R21, R22, R23) et une borne du second condensateur variable (VR2).

5. Système de stockage d'énergie, comprenant :
une batterie (10) comportant une pluralité de blocs-batteries (P1, P2, P3, Pi, Pn), chaque bloc-batterie comportant une pluralité d'éléments de batterie ;
une pluralité de systèmes de gestion de batterie « BMS » (30) esclaves selon l'une quelconque des revendications 1 à 4 configurés pour gérer chacun de la pluralité de blocs-batteries (P1, P2, P3, Pi, Pn) ; et
un BMS maître configuré pour gérer la pluralité de BMS esclaves par le biais d'une communication de réseau de zone de contrôleur « CAN ».

6. Système de stockage d'énergie selon la revendication 5, dans lequel :
chacun de la pluralité de BMS esclaves reçoit un signal de commande de commutation provenant du BMS maître par le biais de la ligne de communication de CAN et commande l'unité de commutation (SW1, SW2) selon le signal de commande de commutation.

7. Système de batterie, comportant :
une batterie comportant une pluralité de blocs-batteries (P1, P2, P3, Pi, Pn), chaque bloc-batterie comportant une pluralité d'éléments de batterie ;
une pluralité de systèmes de gestion de batterie « BMS » (30) esclaves selon l'une quelconque des revendications 1 à 4 configurés pour gérer chacun de la pluralité de blocs-batteries ; et
un BMS maître configuré pour gérer la pluralité de BMS esclaves par le biais d'une communication de réseau de zone de contrôleur « CAN ».

8. Système de batterie selon la revendication 7, dans lequel :
chacun de la pluralité de BMS esclaves reçoit un signal de commande de commutation provenant du BMS maître par le biais de la ligne de communication de CAN et commande l'unité de commutation (SW1, SW2) selon le signal de commande de commutation.
